# EUROPEAN PATENT APPLICATION

(11) **EP 4 845 351 A1**
(43) Date of publication of application: **25.11.2026**
(21) Application number: 25197742.7
(22) Date of filing: 22.08.2025
(51) Int. Cl.: H10F 30/10

(54) **LIGHT SENSOR**

(30) Priority: 22.05.2025 TW 114119275
(71) Applicant: National Taiwan University of Science and Technology, Taipei (TW)
(72) Inventor: CHEN, Ruei-San, Taipei city (TW); WANG, Jyh-Shyang, Taoyuan city (TW)
(74) Representative: Cabinet Beaumont

(57) **Abstract**

A light sensor includes a lower electrode layer, an absorption layer and an upper electrode layer. The absorption layer is located on the lower electrode layer, in which the absorption layer is a single material and free of homojunctions or heterojunctions. The upper electrode layer is located on an upper surface of the absorption layer, in which a ratio of a perimeter of the upper electrode layer to an area of the upper surface of the absorption layer is larger than 100 mm⁻¹. The absorption layer is configured to generate a photogenerated current and a photogenerated voltage using an extreme difference between an electron mobility and a hole mobility near an interface between a periphery of the upper electrode layer and the upper surface of the absorption layer.

## Description

### BACKGROUND

### Technical field

The present disclosure relates to a light sensor, and more particularly, to a light sensor having a junctionless self-powered absorption layer.

### Description of Related Art

High-performance light sensor technology is a critically important aspect of today's high-tech industry. Conventionally, high-performance light sensors utilize semiconductor PN junctions or metal-semiconductor Schottky junction diodes. Through these two methods, a built-in electric field is generated to separate electron-hole pairs, thereby generating a photocurrent. Such methods exhibit an excellent efficiency in visible and ultraviolet light bands, but in mid- to far-infrared bands, it is limited by the intrinsic carrier concentration and excessive dark current of narrow-bandgap semiconductor materials under non-cooled conditions. As a result, the efficiency of the sensor cannot be further improved.

### SUMMARY

One technical aspect of the present disclosure is a light sensor.

According to one embodiment of the present disclosure, a light sensor comprises a lower electrode layer, an absorption layer, and an upper electrode layer. The absorption layer is located on the lower electrode layer, wherein the absorption layer is a single material and free of homojunctions or heterojunctions, the absorption layer comprises a material having an electron mobility required to be greater than 300 cm²/Vs and greater than twice a hole mobility, and the absorption layer is unbiased and self-powered. The upper electrode layer is located on an upper surface of the absorption layer, wherein a ratio of a perimeter of the upper electrode layer to an area of the upper surface of the absorption layer is greater than 100 mm⁻¹. The absorption layer is configured to generate a photogenerated current using an extreme difference between the electron mobility and the hole mobility near an interface between a periphery of the upper electrode layer and the upper surface of the absorption layer. Electrical contacts between the absorption layer and the upper electrode layer and between the absorption layer and the lower electrode layer need to be made into ohmic contacts.

In one embodiment of the present disclosure, a top-view shape of the upper electrode layer is at least one of a comb shape, a branch shape, a mesh shape, and a spiral shape.

In one embodiment of the present disclosure, the upper electrode layer is located in a trench of the absorption layer.

In one embodiment of the present disclosure, the light sensor further comprises a substrate and a buffer layer. The substrate is located between the absorption layer and the lower electrode layer. The buffer layer is located between the substrate and the absorption layer.

In one embodiment of the present disclosure, the light sensor further comprises a substrate and a buffer layer. The substrate is located below the absorption layer and the lower electrode layer. The buffer layer is located between the substrate and the absorption layer.

In one embodiment of the present disclosure, the light sensor further comprises a high-electron-concentration region. The high-electron-concentration region is located between the lower electrode layer and the absorption layer.

In one embodiment of the present disclosure, the absorption layer is L-shaped to form a stepped structure.

In one embodiment of the present disclosure, the light sensor further comprises a doped region. The doped region is disposed below the lower electrode layer and the absorption layer.

Another technical aspect of the present disclosure is a light sensor.

According to one embodiment of the present disclosure, a light sensor comprises an absorption layer, a lower electrode layer, a light-transmissive upper electrode layer, and a metal upper electrode layer. The absorption layer has a first surface and a second surface, the absorption layer comprises a material having an electron mobility required to be greater than 300 cm²/Vs and greater than twice a hole mobility, and the absorption layer is unbiased and self-powered. The lower electrode layer is located on the first surface of the absorption layer. The light-transmissive upper electrode layer is located on the second surface of the absorption layer and covers the second surface, and the absorption layer is configured to generate a photogenerated current using an extreme difference between the electron mobility and the hole mobility near an interface between the light-transmissive upper electrode layer and the absorption layer. The metal upper electrode layer is located on the light-transmissive upper electrode layer, wherein an area of the metal upper electrode layer is less than an area of the light-transmissive upper electrode layer.

In one embodiment of the present disclosure, a bandgap of the light-transmissive upper electrode layer is greater than or equal to 1.5 times a bandgap of the absorption layer.

In one embodiment of the present disclosure, the first surface is disposed opposite to the second surface.

In one embodiment of the present disclosure, the light sensor further comprises a high-electron-concentration region. The high-electron-concentration region is located between the lower electrode layer and the absorption layer.

In one embodiment of the present disclosure, the first surface and the second surface are disposed adjacent to each other and form a stepped surface.

In one embodiment of the present disclosure, the light sensor further comprises a doped region. The doped region is located below the lower electrode layer and the absorption layer.

In one embodiment of the present disclosure, an electron concentration of the light-transmissive upper electrode layer is denoted as nₙ and an electron concentration of the absorption layer is denoted as nₚ, then the light-transmissive upper electrode layer and the absorption layer must satisfy the following relational expressions: ${n}_{n} ≧ {10}^{17} {cm}^{- 3} , {n}_{p} ≦ {10}^{14} {cm}^{- 3}$ wherein a unit of the electron concentration is (cm⁻³).

In one embodiment of the present disclosure, an electron affinity of the light-transmissive upper electrode layer is denoted as χₙ, a work function of the light-transmissive upper electrode layer is denoted as Φₙ, an electron affinity of the absorption layer is denoted as χₚ, and a work function of the absorption layer is denoted as Φₚ, then the light-transmissive upper electrode layer and the absorption layer must satisfy one of the following relational expressions: $\left\{\begin{matrix}{χ}_{p} \leq {χ}_{n} , {Φ}_{p} \geq {Φ}_{n} \\ {χ}_{p} < {χ}_{n} , {Φ}_{p} < {Φ}_{n} \\ {χ}_{p} > {χ}_{n} , {Φ}_{p} > {Φ}_{n}\end{matrix}\right. .$

In the aforementioned embodiments of the present disclosure, since the light sensor generates the photocurrent using the extreme difference between the electron mobility and the hole mobility, it can operate independently at room temperature without the assistance of a cooling system and an external bias voltage, thereby enabling high-detectivity light sensing and high-resolution image sensing. Furthermore, since the ratio of the perimeter of the upper electrode layer to the area of the upper surface of the absorption layer is greater than 100 mm⁻¹, the sensing efficiency is high, and thus, the light sensor is particularly suitable for applications in the infrared light wavelength coverage.

### BRIEF DESCRIPTION OF THE DRAWINGS

FIG. 1 illustrates a perspective view of a light sensor according to an embodiment of the present disclosure.
FIG. 2A illustrates a cross-sectional view of the light sensor in FIG. 1.
FIG. 2B illustrates a cross-sectional view of a light sensor according to another embodiment of the present disclosure.
FIG. 3A illustrates a top view of the light sensor in FIG. 1.
FIG. 3B illustrates a cross-sectional view of a light sensor according to yet another embodiment of the present disclosure.
FIG. 3C illustrates a cross-sectional view of a light sensor according to still another embodiment of the present disclosure.
FIG. 3D illustrates a cross-sectional view of a light sensor according to still another embodiment of the present disclosure.
FIG. 4A illustrates a cross-sectional view of a light sensor according to still another embodiment of the present disclosure.
FIG. 4B illustrates a cross-sectional view of a light sensor according to still another embodiment of the present disclosure.
FIG. 5A illustrates a cross-sectional view of a light sensor according to yet another embodiment of the present disclosure.
FIG. 5B illustrates a cross-sectional view of a light sensor according to still another embodiment of the present disclosure.
FIG. 6 illustrates a cross-sectional view of a light sensor according to still another embodiment of the present disclosure.
FIGS. 7A, 7B, and 7C illustrate band alignment diagrams of the light sensor in FIG. 6 under different conditions.
FIG. 8 illustrates a cross-sectional view of a light sensor according to still another embodiment of the present disclosure.
FIG. 9A illustrates a cross-sectional view of a light sensor according to still another embodiment of the present disclosure.
FIG. 9B illustrates a cross-sectional view of a light sensor according to still another embodiment of the present disclosure.
FIG. 9C illustrates a cross-sectional view of a light sensor according to still another embodiment of the present disclosure.

### DETAILED DESCRIPTION

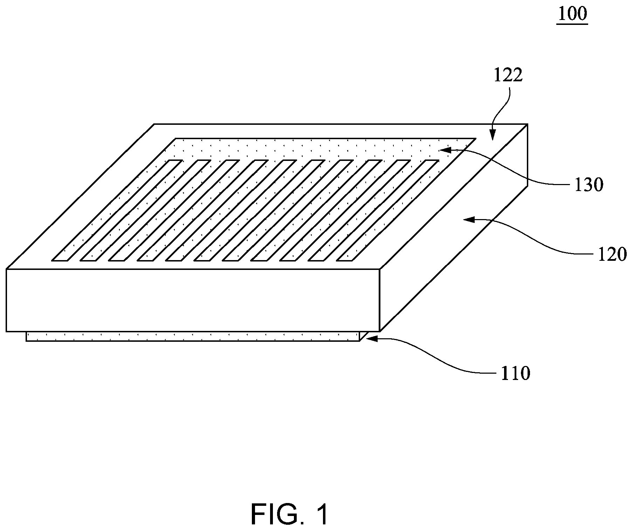

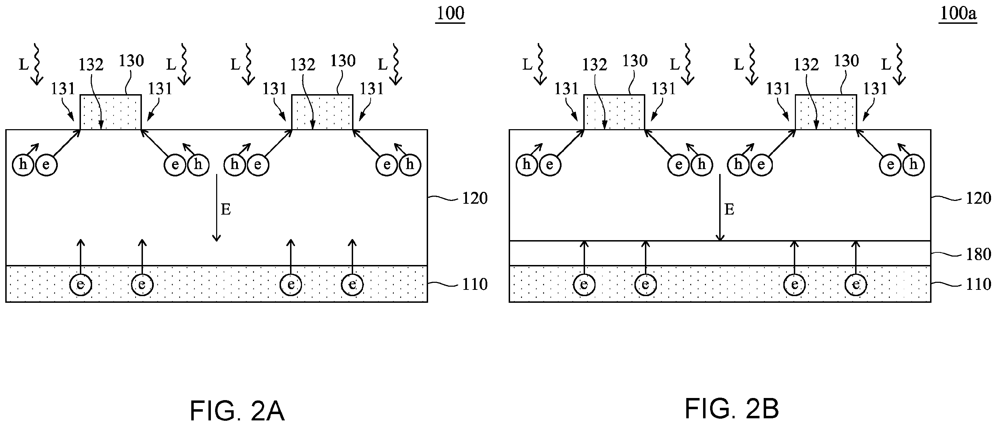

FIG. 1 illustrates a perspective view of a light sensor 100 according to an embodiment of the present disclosure. FIG. 2A illustrates a cross-sectional view of the light sensor 100 in FIG. 1. Referring to FIG. 1 and FIG. 2A, the light sensor 100 includes a lower electrode layer 110, an absorption layer 120, and an upper electrode layer 130. The absorption layer 120 is located on the lower electrode layer 110, where the absorption layer 120 is a single material and free of homojunctions or heterojunctions (i.e., free of internal junction), and the absorption layer 120 includes a material having an electron mobility required to be greater than 300 cm²/Vs and greater than twice a hole mobility, so that the absorption layer 120 is unbiased and self-powered. That is, the light sensor 100 has a junctionless self-powered absorption layer 120 that, when receiving light, generates a voltage and a current without the need for an external power supply. The upper electrode layer 130 is located on an upper surface 122 of the absorption layer 120, where the absorption layer 120 is configured to generate a photogenerated current using an extreme difference between the electron mobility and the hole mobility near an interface between a periphery of the upper electrode layer 130 and the upper surface 122 of the absorption layer 120. When a semiconductor or semimetal material (e.g., the absorption layer 120) is excited by light L, electron-hole pairs are generated. At this time, due to sufficiently high electron mobilities and extreme differences between electron and hole mobilities in certain specific materials (described in detail below), a thermal velocity of electrons becomes significantly faster than that of holes. When the electron-hole pairs are generated by light illumination around the upper electrode layer 130 (e.g., a boundary 131 of the upper electrode layer 130 and an interface 132 between the upper electrode layer 130 and the absorption layer 120), fast photoelectrons (e in the upper part of FIG. 2A) spontaneously enter the upper electrode layer 130 and slow photoholes (h in FIG. 2A) remain. These photoholes deprived of the photoelectrons form positive charges around the upper electrode layer 130. Compared to the lower electrode layer 110 where no positive charges are generated (no light reaches), a vertically downward electric field E and a photovoltage can be generated within an element, thereby driving the flow of carriers within the absorption layer 120 to generate a photocurrent. In order to avoid the interference of the built-in electric field of the metal-semiconductor junction, electrical contacts between the absorption layer 120 and the upper electrode layer 130 and between the absorption layer 120 and the lower electrode layer 110 need to be made into ohmic contacts. Representative materials having a high electron mobility and an extreme difference between the electron mobility and a hole mobility include indium arsenide (InAs), indium antimonide (InSb), indium phosphide (InP), gallium arsenide (GaAs), gallium antimonide (GaSb), indium gallium arsenide (In_{0.53}Ga_{0.47}As), mercury cadmium telluride (Hg₁₋ₓCdₓTe), cadmium arsenide (Cd₃As₂), combinations of the above materials, alloys thereof, or other suitable materials. Table 1 shows the electron and hole mobilities of the above materials at room temperature:

**Table 1**

| Material | Electron Mobility ( $\frac{{cm}^{2}}{Vs}$) | **Hole Mobility** ( $\frac{{cm}^{2}}{Vs}$) |
|---|---|---|
| InAs | 30000 | 200 |
| InSb | 80000 | 800 |
| InP | 4000 | 100 |
| GaAs | 8500 | 400 |
| GaSb | 5000 | 1000 |
| In_{0.53}Ga_{0.47}As | 13800 | 500 |
| Hg₁₋ₓCdₓTe | 10000 | 100 |
| Cd₃As₂ | 15000 | 500 |

As can be seen from Table 1, the above materials exhibit an extreme difference between the electron and hole mobilities at room temperature, with the electron mobility being at least twice the hole mobility, and even reaching a hundred-fold difference (e.g., InSb). Therefore, these materials can be used as the absorption layer 120 of the light sensor 100. The lower electrode layer 110 is configured to supply electrons to form a complete current loop within the light sensor 100.

FIG. 2B illustrates a cross-sectional view of a light sensor 100a according to yet another embodiment of the present disclosure. Referring to FIG. 2B, the embodiment in FIG. 2B differs from that in FIG. 2A in that, in the present embodiment, the light sensor 100a further includes a high-electron-concentration region 180 having an electron concentration required to be greater than 10¹⁴ cm⁻³. The high-electron-concentration region 180 is located between the lower electrode layer 110 and the absorption layer 120. The high-electron-concentration region 180 can provide a region where positive charge accumulation cannot be generated, thus preventing light L from potentially penetrating through the entire absorption layer 120 to reach the lower electrode layer 110 when the absorption layer 120 is thinned. This thereby prevents an interface between the lower electrode layer 110 and the absorption layer 120 from generating a photogenerated current (or voltage) directed toward the upper electrode layer 130, which would offset or reduce a photogenerated current (directed toward the lower electrode layer 110) originally generated at the boundary 131 and the interface 132 between the upper electrode layer 130 and the absorption layer 120. In some embodiments, the high-electron-concentration region 180 includes an intrinsic or N-type semiconductor homogeneous or heterogeneous with the absorption layer 120, but the present disclosure is not limited thereto.

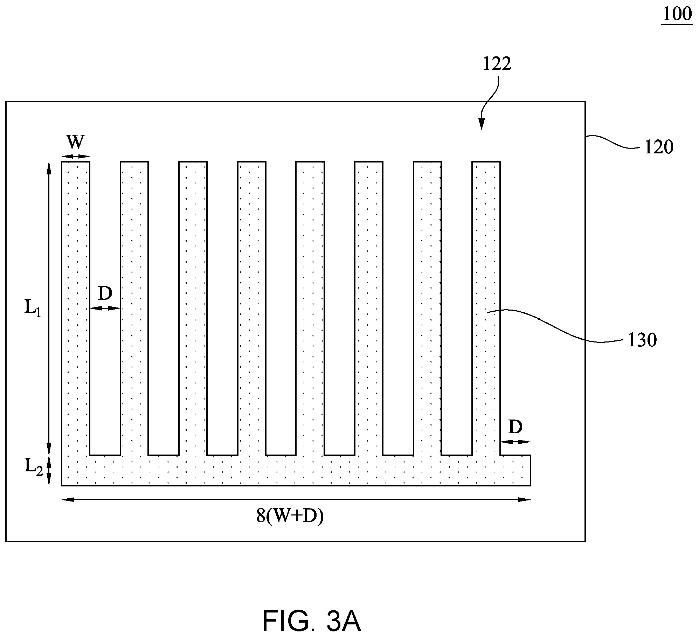

FIG. 3A illustrates a top view of the light sensor 100 in FIG. 1. Referring to FIG. 3A, when a perimeter of the upper electrode layer 130 is calculated, with an embodiment of a comb-shaped electrode in FIG. 3A as an example, a total perimeter of the upper electrode layer 130 can be represented by Equation 1 as follows: $L = 2 N \left(W+D\right) + 2 N {L}_{1} + 2 {L}_{2}$ Equation 1

Where L is the perimeter of the upper electrode layer 130, W is a width of one finger electrode, D is a spacing between two finger electrodes, L₁ is a length of one finger electrode, L₂ is a width of a bus bar connecting the finger electrodes, and N is the number of the finger electrode (with FIG. 3A as an example, N=8). It can be seen from the above equation that when the number N of the finger electrode increases, the perimeter L will also increase accordingly. In practical applications, the width W of the finger electrode is typically on the micrometer scale, for example, within the range of 1 micrometer to 10 micrometers, but the present disclosure is not limited thereto. An area of the upper surface 122 of the absorption layer 120 is defined as an area of a region occupied by the upper electrode layer 130 on the upper surface 122 of the absorption layer 120. With the embodiment of the comb-shaped electrode in FIG. 3A as an example, the area of the upper surface 122 of the absorption layer 120 can be represented by Equation 2 as follows: $A = N \left(W+D\right) \times \left({L}_{1}+{L}_{2}\right)$ Equation 2 where A is the area of the upper surface 122 of the absorption layer 120.

**In** practical applications, the area of the upper surface 122 of the absorption layer 120 is within the range of 1 square millimeter to 9 square millimeters, for example, 4 square millimeters, but is not limited thereto. In view of this, a ratio of the perimeter L of the upper electrode layer 130 of the light sensor 100 to the area A of the upper surface 122 of the absorption layer 120 is greater than 100 mm⁻¹, for example, 2500 mm⁻¹, but the present disclosure is not limited thereto. Since most of photogenerated charges used to generate a photovoltage in the present embodiment are generated around the upper electrode layer 130 (e.g., at the boundary 131 of the upper electrode layer 130 and the interface 132 between the upper electrode layer 130 and the absorption layer 120), maximizing the perimeter L of the upper electrode layer 130 of the light sensor 100 within a limited area can improve a generation efficiency of the photogenerated charges of the light sensor 100. In addition, the top-view shape of the upper electrode layer 130 is not limited to a comb shape and can also be at least one of a branch shape, a mesh shape, or a spiral shape.

Since the light sensor 100 generates a photocurrent using an extreme difference between the electron mobility and the hole mobility, it can operate independently at room temperature without the assistance of a cooling system and an external bias voltage, thereby providing high-detectivity light sensing and high-resolution image sensing. Moreover, due to the ratio of the perimeter of the upper electrode layer 130 to the area of the upper surface 122 of the absorption layer 120 being greater than 100 mm⁻¹, a photoresponse signal is large and a background dark current is small, so a signal-to-noise ratio under uncooled conditions may be very high. Therefore, the light sensor is particularly suitable for applications in infrared wavelength bands.

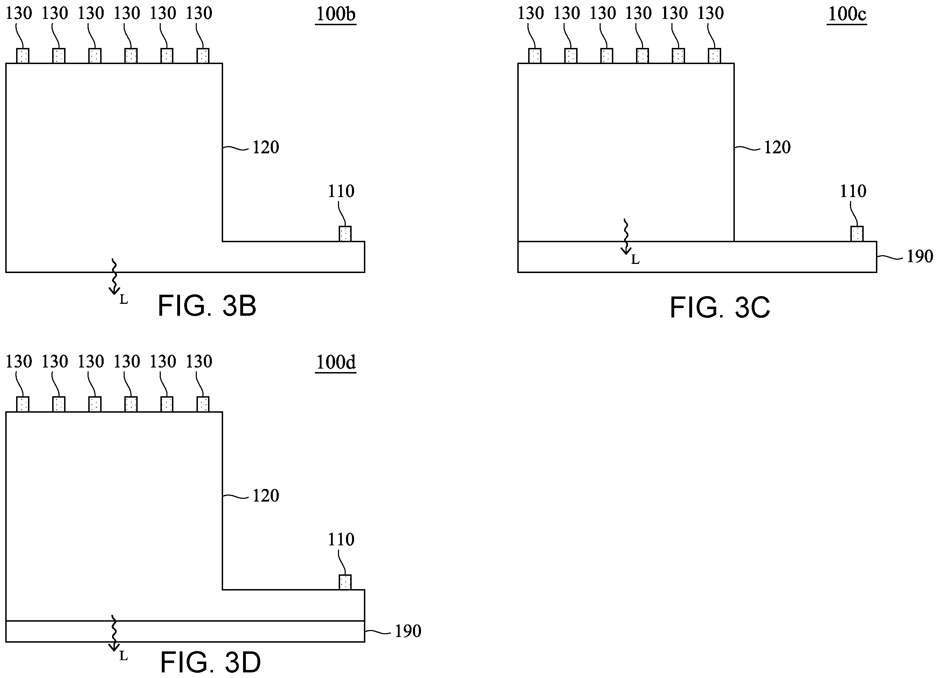

FIG. 3B illustrates a cross-sectional view of a light sensor 100b according to yet another embodiment of the present disclosure. Referring to FIG. 3B, the light sensor 100b includes a lower electrode layer 110, an absorption layer 120, and an upper electrode layer 130. When the absorption layer 120 in FIG. 2A is thinned, light L may penetrate through the entire absorption layer 120 of FIG. 2A to reach the lower electrode layer 110, and then a photogenerated current (or voltage) directed toward the upper electrode layer 130 is generated at the interface between the lower electrode layer 110 and the absorption layer 120 in FIG. 2A to offset or reduce a photogenerated current (directed toward the lower electrode layer 110) originally generated between the upper electrode layer 130 and the absorption layer 120 in FIG. 2A. The embodiment of FIG. 3B differs from the embodiment of FIG. 2A in that the absorption layer 120 in FIG. 3B is fabricated into an L-shape (stepped structure), and the lower electrode layer 110 is fabricated on an upper surface of a thinner portion of the absorption layer 120, to overcome the above issue of the photogenerated current being offset.

FIG. 3C illustrates a cross-sectional view of a light sensor 100c according to still another embodiment of the present disclosure. Referring to FIG. 3C, the light sensor 100c includes a lower electrode layer 110, an absorption layer 120, and an upper electrode layer 130. The present embodiment differs from the embodiment of FIG. 3B in that the light sensor 100c of the present embodiment further includes a doped region 190. The doped region 190 is located below the lower electrode layer 110 and the absorption layer 120. The doped region 190 may increase a conductivity of a bottom of the light sensor 100c. In some embodiments, the doped region 190 includes a heavily doped P-type semiconductor material homogeneous or heterogeneous with the absorption layer 120, but the present disclosure is not limited thereto.

For ease of fabrication, the design of the doped region 190 in FIG. 3C may also be combined with the L-shaped absorption layer 120 of FIG. 3B, i.e., the doped region 190 is fabricated below the L-shaped absorption layer 120 of FIG. 3B, as shown in a light sensor 100d of FIG. 3D.

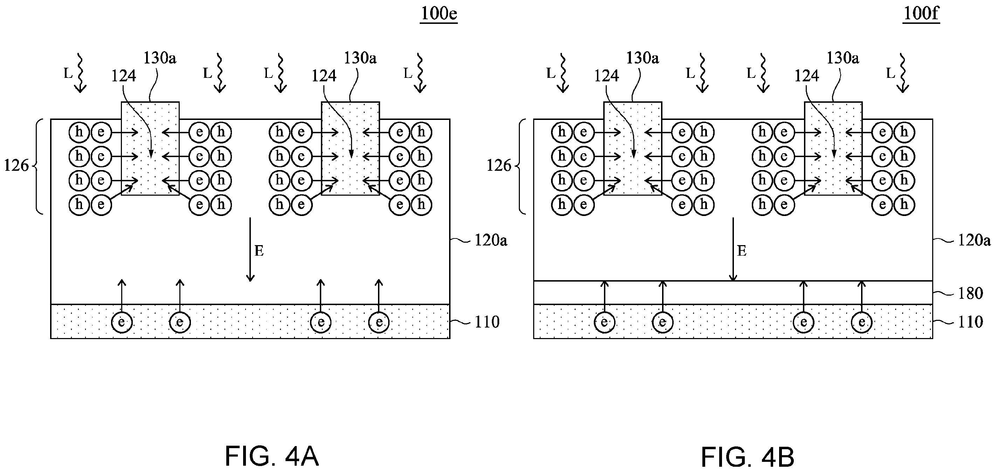

FIG. 4A illustrates a cross-sectional view of a light sensor 100e according to yet another embodiment of the present disclosure. Referring to FIG. 4A, the light sensor 100e includes a lower electrode layer 110, an absorption layer 120a, and an upper electrode layer 130a. The absorption layer 120a is located on the lower electrode layer 110, and the upper electrode layer 130a is located on the absorption layer 120a which is configured to absorb electrons e in a photocurrent. The present embodiment differs from the embodiment of FIG. 2A in that, in the present embodiment, the absorption layer 120a has a trench 124, and a portion of the upper electrode layer 130a is located within the trench 124. Since the entry of photoelectrons into the upper electrode layer 130a is driven by a spontaneous thermal velocity and thermal scattering mechanism, and the quantity of the photoelectrons entering an electrode is determined by their mean collision length, a higher electron mobility results in a longer mean collision length, indicating that more photoelectrons can enter the electrode. However, in general, the mean collision length of the electrons is significantly less than 1 micrometer, which leads to a shallower depth of a positive charge generation region (active region) in the present disclosure. Yet, a light penetration depth in the absorption layer 120 (as in the embodiment of FIG. 2A) is typically greater than 1 micrometer. This result will cause an internal quantum efficiency of the light sensor to be relatively low. Therefore, the trench 124 with an electrode pattern as shown in FIG. 4A may first be formed in the absorption layer 120a through processes such as etching, and then a metal electrode is filled into the trench 124. As a result, a range of collectible electrons will no longer be limited to a region around the electrode near a surface layer (e.g., the boundary 131 of the upper electrode layer 130), but can instead increase as an electrode depth (such as a depth of a photogenerated positive charge region 126) increases.

FIG. 4B illustrates a cross-sectional view of a light sensor 100f according to still another embodiment of the present disclosure. Referring to FIG. 4B, the present embodiment differs from the embodiment of FIG. 4A in that the light sensor 100f of the present embodiment further includes a high-electron-concentration region 180, and the high-electron-concentration region 180 is located between the lower electrode layer 110 and the absorption layer 120a. The high-electron-concentration region 180 is configured to provide a region where positive charge accumulation cannot be generated.

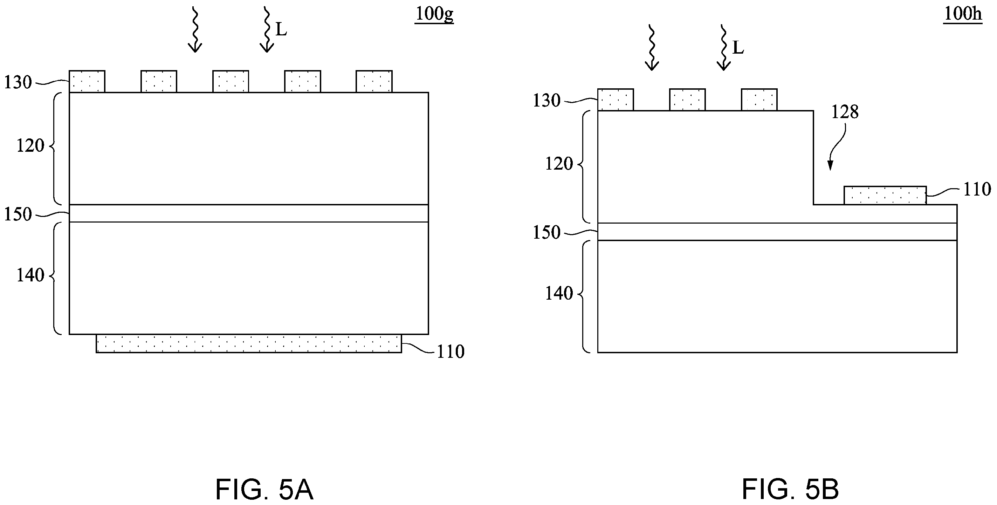

FIG. 5A illustrates a cross-sectional view of a light sensor 100g according to yet another embodiment of the present disclosure. Referring to FIG. 5A, the light sensor 100g includes a lower electrode layer 110, an absorption layer 120, and an upper electrode layer 130. The absorption layer 120 is located on the lower electrode layer 110, where the absorption layer 120 is a single material and free of homojunctions or heterojunctions. The present embodiment differs from the embodiment of FIG. 1 in that the light sensor 100g further includes a substrate 140, and the substrate 140 is located between the absorption layer 120 and the lower electrode layer 110. In some embodiments, the absorption layer 120 may be grown on any conductive substrate via epitaxy, chemical vapor deposition (CVD), a combination thereof, or other suitable methods. In some embodiments, if a lattice constant of the substrate 140 differs too greatly from that of the absorption layer 120, an epitaxial buffer layer 150 may be additionally grown between the substrate 140 and the absorption layer 120, but the present disclosure is not limited thereto.

FIG. 5B illustrates a cross-sectional view of a light sensor 100h according to still another embodiment of the present disclosure. The light sensor 100h includes a lower electrode layer 110, an absorption layer 120, an upper electrode layer 130, a substrate 140, and a buffer layer 150. The present embodiment differs from the embodiment of FIG. 5A in that, in the present embodiment, the lower electrode layer 110 is located at a recess 128 on the upper surface of the absorption layer 120. When the substrate 140 or the buffer layer 150 has an insufficient conductivity or excessively high resistance, a photocurrent may fail to conduct through the substrate or buffer layer. In such cases, the lower electrode layer 110 is not suitable to be fabricated directly below the absorption layer 120 but must instead be fabricated on an upper surface of the recess 128 at the lower-right side of the absorption layer 120 by first etching the absorption layer into an L-shape.

The design of the upper electrode layer 130a in the trench 124 of FIG. 4A may also be incorporated into the embodiments of FIG. 3B, FIG. 3C, FIG. 3D, FIG. 5A, and FIG. 5B.

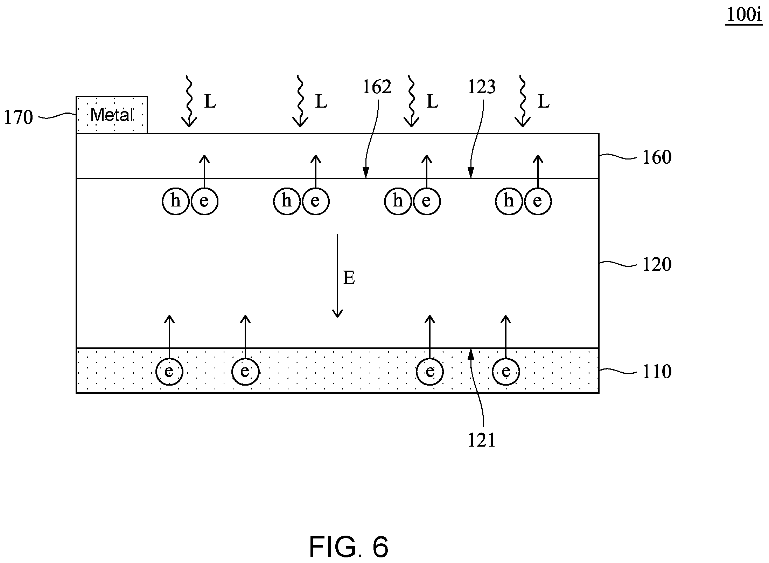

FIG. 6 illustrates a cross-sectional view of a light sensor 100i according to still another embodiment of the present disclosure. Referring to FIG. 6, the light sensor 100i includes an absorption layer 120, a lower electrode layer 110, a light-transmissive upper electrode layer 160, and a metal upper electrode layer 170. The absorption layer 120 has a first surface 121 and a second surface 123, and the absorption layer 120 includes a material having an electron mobility required to be greater than 300 cm²/Vs and greater than twice a hole mobility. The lower electrode layer 110 is located on the first surface 121 of the absorption layer 120. The light-transmissive upper electrode layer 160 is located on the second surface 123 of the absorption layer 120 and fully covers the second surface 123. The absorption layer 120 is configured to generate a photogenerated current using an extreme difference between the electron mobility and the hole mobility near an interface 162 between the light-transmissive upper electrode layer 160 and the absorption layer 120. After electron-hole pairs are generated in the absorption layer 120, photoelectrons e close to the light-transmissive upper electrode layer 160 spontaneously enter the light-transmissive upper electrode layer 160 due to their higher thermal velocity, and photoholes h remain in the absorption layer 120 due to their lower thermal velocity. These retained photoholes h generate positive charges near the interface 162 and generate a vertically downward electric field E and a photovoltage in the absorption layer 120, thereby generating a photogenerated current. In the present embodiment, the first surface 121 and the second surface 123 are located on opposite sides of the absorption layer 120, respectively. The metal upper electrode layer 170 is located on the light-transmissive upper electrode layer 160, where an area of the metal upper electrode layer 170 is less than that of the light-transmissive upper electrode layer 160. In the present embodiment, the light-transmissive upper electrode layer 160 fully covers the absorption layer 120, resulting in a very small ratio of a perimeter of the light-transmissive upper electrode layer 160 to an area of an upper surface (i.e., the second surface 123) of the absorption layer 120. However, since the light-transmissive upper electrode layer 160 in the present embodiment allows light L to penetrate through, photogenerated charges e can be generated across nearly the entire interface 162 between the light-transmissive upper electrode layer 160 and the absorption layer 120 (only a small area blocked by the metallic upper electrode layer 170 cannot generate the photogenerated charges e). Since the light-transmissive upper electrode layer 160 must allow the light L to penetrate through and enable the light L to be absorbed by the absorption layer 120 to generate the photogenerated charges e, a bandgap of a material of the light-transmissive upper electrode layer 160 must be greater than that of a material of the absorption layer 120 to prevent the light L from being absorbed by the light-transmissive upper electrode layer 160 itself. Specifically, the bandgap of the light-transmissive upper electrode layer 160 is greater than or equal to 1.5 times the bandgap of the absorption layer 120. For example, in mid- to far-infrared detector applications, InSb with a bandgap of 0.18 eV may be used as the absorption layer, paired with Ge with a bandgap of 0.66 eV as the light-transmissive upper electrode layer. In some embodiments, the light-transmissive upper electrode layer 160 includes an N-type semiconductor. In some embodiments, the absorption layer 120 includes a P-type semiconductor. Additionally, the light-transmissive upper electrode layer 160 requires moderate doping to achieve sufficient carrier concentration and conductivity, but its internal carrier concentration must not be so high as to cause free-electron absorption, which would result in infrared light being absorbed by the light-transmissive upper electrode layer 160. Specifically, an electron concentration of the light-transmissive upper electrode layer 160 must be greater than 10¹⁷ cm⁻³. To prolong a hole lifetime, the electron concentration of the absorption layer 120 must also be minimized. The electron concentration of the absorption layer 120 must be less than 10¹⁴ cm⁻³.

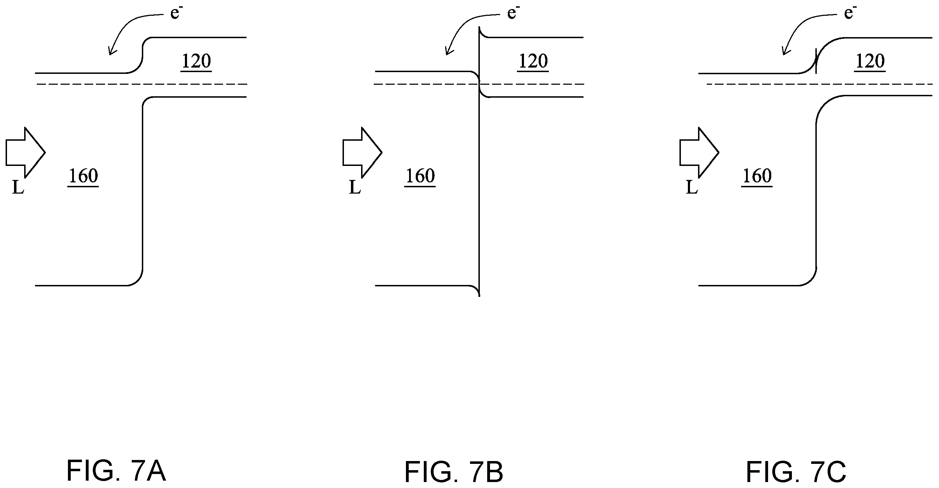

FIGS. 7A, 7B, and 7C illustrate band alignment diagrams of the light sensor 100i in FIG. 6 under different conditions. Referring to FIGS. 7A, 7B, and 7C, if an electron affinity of the light-transmissive upper electrode layer 160 (typically n-type) is denoted as χₙ, a work function of the light-transmissive upper electrode layer 160 is denoted as Φₙ, an electron concentration of the light-transmissive upper electrode layer 160 is denoted as nₙ, an electron affinity of the absorption layer 120 (typically p-type) is denoted as χₚ, a work function of the absorption layer 120 is denoted as Φₚ, and an electron concentration of the absorption layer 120 is denoted as nₚ, then the light-transmissive upper electrode layer 160 and the absorption layer 120 need to satisfy the following relational expressions: ${n}_{n} ≧ {10}^{17} {cm}^{- 3} , {n}_{p} ≦ {10}^{14} {cm}^{- 3} ;$ furthermore, the light-transmissive upper electrode layer 160 and the absorption layer 120 need to satisfy one of the following relational expressions: $\left\{\begin{matrix}{χ}_{p} \leq {χ}_{n} , {Φ}_{p} \geq {Φ}_{n} … Equation 2 - 1 \\ {χ}_{p} < {χ}_{n} , {Φ}_{p} < {Φ}_{n} … Equation 2 - 2 \\ {χ}_{p} > {χ}_{n} , {Φ}_{p} > {Φ}_{n} … Equation 2 - 3\end{matrix}\right. .$

If it is the case of Equation 2-1, then a band alignment between the light-transmissive upper electrode layer 160 and the absorption layer 120 is as shown in FIG. 7A. If it is the case of Equation 2-2, then the band alignment between the light-transmissive upper electrode layer 160 and the absorption layer 120 is as shown in FIG. 7B. If it is the case of Equation 2-3, then the band alignment between the light-transmissive upper electrode layer 160 and the absorption layer 120 is as shown in FIG. 7C. These constraints are to avoid formation of a potential barrier at the interface 162 between the light-transmissive upper electrode layer 160 and the absorption layer 120 during a transport process of photogenerated electrons e via thermal velocity or thermal scattering, which could prevent photoelectrons e from entering the light-transmissive upper electrode layer 160 from the absorption layer 120, resulting in the failure to generate a photovoltage and a decrease in the efficiency of the light sensor 100i.

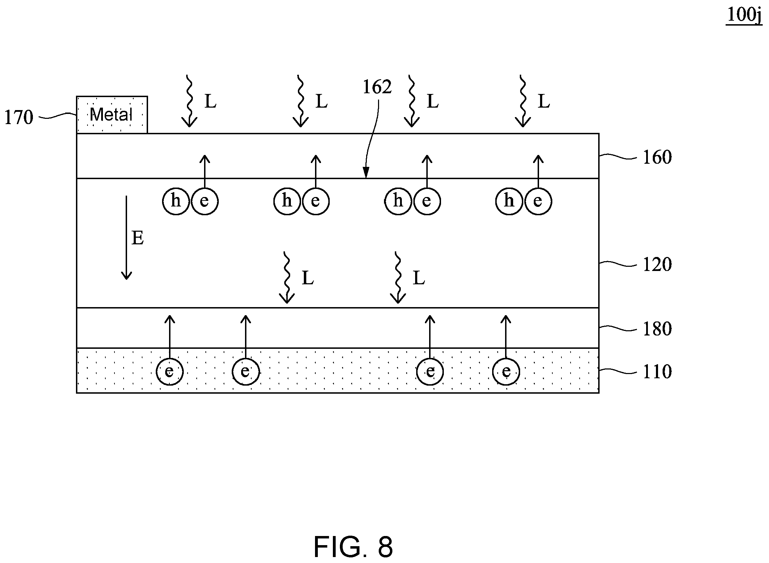

FIG. 8 illustrates a cross-sectional view of a light sensor 100j according to still another embodiment of the present disclosure. Referring to FIG. 8, the light sensor 100j includes an absorption layer 120, a lower electrode layer 110, a light-transmissive upper electrode layer 160, and a metal upper electrode layer 170. The present embodiment differs from the embodiment of FIG. 6 in that, in the present embodiment, the light sensor 100j may further include a high-electron-concentration region 180 having an electron concentration greater than 10¹⁴ cm⁻³. The high-electron-concentration region (layer) 180 is located between the lower electrode layer 110 and the absorption layer 120. When the absorption layer 120 is thinned during element fabrication, light L may penetrate through the entire absorption layer 120 to reach the lower electrode layer 110, and then a photogenerated current (or voltage) directed towards the light-transmissive upper electrode layer 160 is generated at the interface between the lower electrode layer 110 and the absorption layer 120 to offset a photogenerated current (directed towards the lower electrode layer 110) originally generated at the interface 162 between the light-transmissive upper electrode layer 160 and the absorption layer 120. The high-electron-concentration region 180 can provide a region where positive charge accumulation cannot be generated. In some embodiments, the high-electron-concentration region 180 includes an intrinsic or N-type semiconductor homogeneous or heterogeneous with the absorption layer 120, but the present disclosure is not limited thereto.

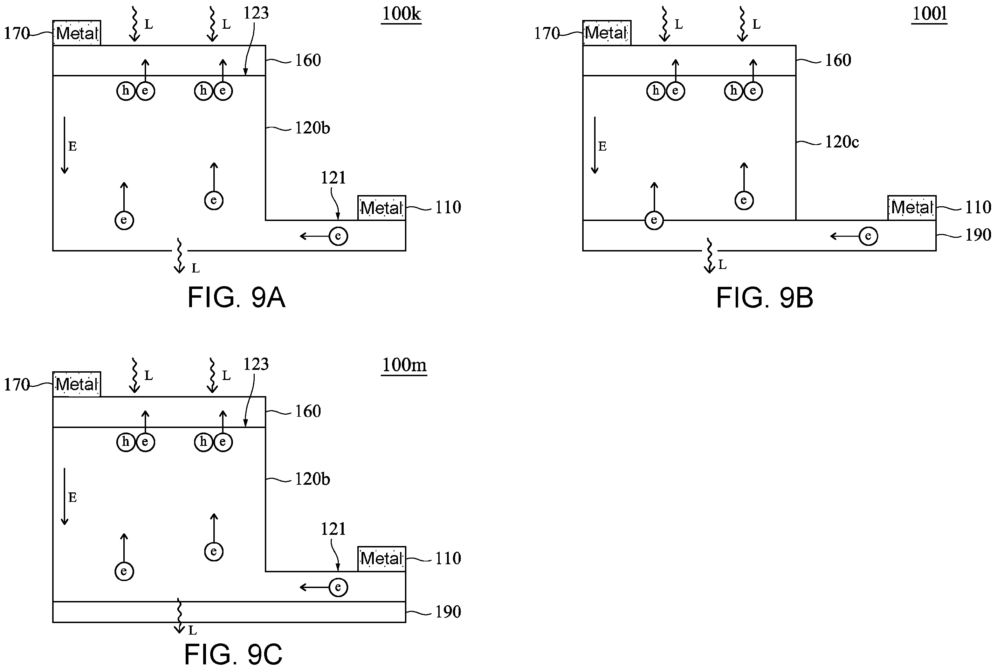

FIG. 9A illustrates a cross-sectional view of a light sensor 100k according to yet another embodiment of the present disclosure. Referring to FIG. 9A, the light sensor 100k includes an absorption layer 120b, a lower electrode layer 110, a light-transmissive upper electrode layer 160, and a metal upper electrode layer 170. The present embodiment differs from the embodiment of FIG. 6 in that, in the present embodiment, both the first surface 121 and the second surface 123 face light L, and the first surface 121 and the second surface 123 are disposed adjacent to each other and form a stepped surface. By changing a position of the lower electrode layer 110 to have an offset from the light-transmissive upper electrode layer 160 in the horizontal direction, an issue of the light L reaching an interface between the lower electrode layer 110 and the absorption layer 120b due to element thinning, thereby generating a photogenerated current (or voltage) directed toward the light-transmissive upper electrode layer 160, is avoided.

FIG. 9B illustrates a cross-sectional view of a light sensor 100I according to still another embodiment of the present disclosure. Referring to FIG. 9B, the light sensor 100I includes an absorption layer 120c, a lower electrode layer 110, a light-transmissive upper electrode layer 160, and a metal upper electrode layer 170. The present embodiment differs from the embodiment of FIG. 9A in that, in the present embodiment, the light sensor 100I may further include a doped region 190. The doped region 190 is located below the lower electrode layer 110 and the absorption layer 120c. The doped region 190 can enhance a conductivity of a bottom of the light sensor 100I. In some embodiments, the doped region 190 includes a heavily doped P-type semiconductor material homogeneous or heterogeneous with the absorption layer 120c, but this does not limit the present disclosure.

For ease of fabrication, the design of the doped region 190 of FIG. 9B may also be combined with the L-shaped absorption layer 120b of FIG. 9A, i.e., the doped region 190 is fabricated below the L-shaped absorption layer 120b of FIG. 9A, as shown in the light sensor 100m of FIG. 9C.

Although the present disclosure is primarily designed for infrared light sensing under non-cooled conditions, in certain special cases, due to the excessively low bandgap of the material of the absorption layer 120 (e.g., InAs, InSb, InAsSb, HgCdTe having a bandgap of less than 0.4 eV), the intrinsic electron concentration at room temperature becomes too high. If the electron concentration cannot be reduced to a target concentration (e.g., 10¹⁴ cm⁻³) via P-type doping, operationally the electron concentration can still be lowered by operating at an appropriately low temperature environment, thereby extending the hole lifetime and enhancing the photovoltage.

## Claims

1. A light sensor, comprising:
a lower electrode layer (110);
an absorption layer (120) located on the lower electrode layer (110), wherein the absorption layer (120) is a single material and free of homojunctions or heterojunctions, the absorption layer (120) comprises a material having an electron mobility required to be greater than 300 cm²/Vs and greater than twice a hole mobility, and the absorption layer (120) is unbiased and self-powered; and
an upper electrode layer (130) located on an upper surface of the absorption layer (120), wherein a ratio of a perimeter of the upper electrode layer (130) to an area of the upper surface of the absorption layer (120) is greater than 100 mm⁻¹, and the absorption layer (120) is configured to generate a photogenerated current and a photogenerated voltage using an extreme difference between an electron mobility and a hole mobility near an interface between a periphery of the upper electrode layer (130) and the upper surface of the absorption layer (120), and
an electrical contact between the absorption layer (120) and the upper electrode layer (130) and an electrical contact between the absorption layer (120) and the lower electrode layer (110) are both ohmic contacts.

2. The light sensor according to claim 1, wherein a top-view shape of the upper electrode layer (130) is at least one of a comb shape, a branch shape, a mesh shape, and a spiral shape.

3. The light sensor according to claim 2, wherein the upper electrode layer (130a) is located in a trench of the absorption layer (120a).

4. The light sensor according to any one of claims 1-3, further comprising:
a substrate (140) located between the absorption layer (120) and the lower electrode layer (110); and
a buffer layer (150) located between the substrate (140) and the absorption layer (120).

5. The light sensor according to any one of claims 1-3, further comprising:
a substrate (140) located below the absorption layer (120) and the lower electrode layer (110); and
a buffer layer (150) located between the substrate (140) and the absorption layer (120).

6. The light sensor according to any one of claims 1-5, further comprising:
a high-electron-concentration region (180) located between the lower electrode layer (110) and the absorption layer (120).

7. The light sensor according to any one of claims 1-6, further comprising:
a doped region (190) located below the lower electrode layer (110) and the absorption layer (120), wherein the absorption layer (120) is L-shaped to form a stepped structure.

8. A light sensor, comprising:
an absorption layer (120) having a first surface (121) and a second surface (123), wherein the absorption layer (120) comprises a material having an electron mobility required to be greater than 300 cm²/Vs and greater than twice a hole mobility, and the absorption layer (120) is unbiased and self-powered; and
a lower electrode layer (110) located on the first surface (121) of the absorption layer (120);
a light-transmissive upper electrode layer (160) located on the second surface (123) of the absorption layer (120) and covering the second surface (123), wherein the absorption layer (120) is configured to generate a photogenerated current using an extreme difference between the electron mobility and the hole mobility near an interface between the light-transmissive upper electrode layer (160) and the absorption layer (120); and
a metal upper electrode layer (170) located on the light-transmissive upper electrode layer (160), wherein an area of the metal upper electrode layer (170) is less than an area of the light-transmissive upper electrode layer (160).

9. The light sensor according to claim 8, wherein a bandgap of the light-transmissive upper electrode layer (160) is greater than or equal to 1.5 times a bandgap of the absorption layer (120).

10. The light sensor according to any one of claims 8-9, wherein the first surface (121) is disposed opposite the second surface (123).

11. The light sensor according to claim 10, further comprising:
a high-electron-concentration region (180) located between the lower electrode layer (110) and the absorption layer (120).

12. The light sensor according to any one of claims 8-11, wherein the first surface (121) and the second surface (123) are disposed adjacent to each other and form a stepped surface.

13. The light sensor according to claim 12, further comprising:
a doped region (190) located below the lower electrode layer (110) and the absorption layer (120b).

14. The light sensor according to any one of claims 8-13, wherein an electron concentration of the light-transmissive upper electrode layer (160) is denoted as nₙ, and an electron concentration of the absorption layer (120) is denoted as nₚ, then the light-transmissive upper electrode layer (160) and the absorption layer (120) must satisfy the following relational expressions: ${n}_{n} ≧ {10}^{17} {cm}^{- 3} , {n}_{p} ≦ {10}^{14} {cm}^{- 3}$ wherein a unit of the electron concentration is (cm⁻³).

15. The light sensor according to claim 14, wherein an electron affinity of the light-transmissive upper electrode layer (160) is denoted as χₙ, a work function of the light-transmissive upper electrode layer (160) is denoted as Φₙ, an electron affinity of the absorption layer is denoted as χₚ, and a work function of the absorption layer (120) is denoted as Φₚ, then the light-transmissive upper electrode layer (160) and the absorption layer (120) must satisfy one of the following relational expressions: $\left\{\begin{matrix}{χ}_{p} \leq {χ}_{n} , {Φ}_{p} \geq {Φ}_{n} \\ {χ}_{p} < {χ}_{n} , {Φ}_{p} < {Φ}_{n} \\ {χ}_{p} > {χ}_{n} , {Φ}_{p} > {Φ}_{n}\end{matrix}\right. .$
